(19) **Europäisches Patentamt / European Patent Office / Office européen des brevets**

(11) **EP 4 593 241 A1**

(12) # DEMANDE DE BREVET EUROPEEN

(43) Date de publication:
**30.07.2025   Bulletin 2025/31**

(21) Numéro de dépôt: **25154005.0**

(22) Date de dépôt: **27.01.2025**

(51) Classification Internationale des Brevets (IPC):
**H02J 7/00** (2006.01)   **G01R 31/36** (2020.01)
**G01R 31/367** (2019.01)   **G01R 31/382** (2019.01)
**H01M 10/44** (2006.01)

(52) Classification Coopérative des Brevets (CPC):
**H02J 7/007184; G01R 31/3648; G01R 31/367; G01R 31/382; H01M 10/44**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **29.01.2024   FR 2400832**

(71) Demandeur: **BHG**
**68100 Mulhouse (FR)**

(72) Inventeurs:
• **DELPY, Vincent**
  **68510 SIERENTZ (FR)**
• **FRITSCH, Thomas**
  **67800 HOENHEIM (FR)**

(74) Mandataire: **Cabinet Bleger-Rhein-Poupon**
**4a rue de l'Industrie**
**67450 Mundolsheim (FR)**

(54) **PROCÉDÉ D AUTO-PARAMÉTRAGE DES CONDITIONS DE CHARGE D'UNE BATTERIE D'ACCUMULATEURS**

(57) Procédé d'auto-paramétrage des conditions de charge d'une batterie d'accumulateurs électrochimiques, notamment une batterie lithium, ladite batterie étant connectée à une source d'alimentation apte à la charger, comprenant :

la détection d'au moins un point p d'inflexion dans la courbe de tension de charge de la batterie $U_{bat}$ fonction du taux de charge électrique exprimé en pourcentage de la capacité C de la batterie ;

pour chaque point p d'inflexion détecté, une déconnexion de la batterie de sa source d'alimentation pendant une période de relaxation prédéterminée ;

à l'issue de ladite période de relaxation, la mémorisation de la tension à vide $U_{xR}$ de la batterie pour chacun des points d'inflexion, ladite tension à vide $U_{xR}$ constituant un marqueur d'un niveau de charge intermédiaire utilisable comme seuil d'arrêt de charge au cours de la charge d'une batterie.

[Fig. 2]

EP 4 593 241 A1

**Description**

L'invention concerne un procédé d'auto-paramétrage des conditions de charge d'une batterie d'accumulateurs électrochimiques, notamment une batterie lithium, tout particulièrement utilisable dans le contexte spécifique des recharges de batteries dans le but de prolonger leur durée de vie. Ainsi, il est bien connu que ce type de batterie vieillit de manière accélérée lorsque la recharge qu'on leur impose va jusqu'à une charge totale ou quasi-totale, et il est donc fortement conseillé de ne pas les recharger complètement mais d'arrêter leur charge lorsque la batterie a atteint un seuil de recharge intermédiaire, c'est-à-dire un état de charge qui est situé en deçà de la capacité théorique de la batterie.

On connaît bien entendu déjà des méthodes permettant d'arrêter la charge d'une batterie à un état de charge cible sensiblement inférieur à 100% de leur capacité. Le document EP3220471, en particulier, décrit un procédé qui repose sur l'existence d'un ou plusieurs points d'inflexion caractéristiques dans la courbe de tension de charge de la batterie. Ces points particuliers de la courbe, qui sont également décrits dans les documents JP2006351418A et US2024012063A1, définissent des niveaux de charge en principe plus facilement identifiables et qui peuvent être exploités au cours de la recharge pour maximiser la durée de vie de la batterie en évitant de la surcharger, notamment mais non exclusivement lorsque la température ambiante est élevée. Choisir ces points d'inflexion connus et identifiables comme seuils de référence pour la charge présente l'intérêt de limiter l'erreur sur le niveau de charge obtenu, en particulier pour les batteries de technologie LFP (ou LiFePO4) dont la courbe de charge est très plate.

Lorsque la tension de charge atteint le seuil visé, correspondant à un taux de charge de la batterie a priori connu, on déconnecte la batterie de son dispositif d'alimentation pour débuter une phase de relaxation d'une durée prédéfinie (en général quelques minutes) durant laquelle la charge est stoppée. La batterie est considérée comme chargée non pas quand sa tension en charge est supérieure ou égale au seuil cible visé, mais lorsque sa tension à vide après relaxation est supérieure audit seuil cible. Le seuil cible visé est alors considéré comme un seuil d'arrêt, ou une valeur d'arrêt, lors de l'opération de charge de la batterie.

L'inconvénient de cette méthode est que la position et la valeur des points d'inflexion, c'est-à-dire des points de la courbe de charge connus et utilisables comme seuils de référence d'arrêt de charge, dépendent des caractéristiques électrochimiques de la batterie utilisée et peuvent varier de manière assez significative selon le fabricant. Par conséquent, en cas de changement de fournisseur de batterie, il faut refaire la caractérisation complète et redéfinir les nouvelles valeurs des seuils d'arrêt de charge. De même, dans le cadre d'une procédure de maintenance, le remplacement d'une batterie par un modèle équivalent impose de reparamétrer le schéma de charge.

En pratique, le procédé divulgué par EP3220471 comprend de ce fait une étape préalable de configuration lors de laquelle on détermine des données de corrélation entre l'état de charge de la batterie et la tension en circuit ouvert de la batterie. Cette étape de configuration peut être réalisée en laboratoire ou en usine, sur la batterie elle-même ou sur une batterie de référence identique. C'est en particulier cette reconfiguration, en vue d'identifier les caractéristiques intéressantes de la courbe de charge en pratique surtout pour connaître les seuils d'arrêt de charge, qui doit être refaite lorsqu'on remplace une batterie par un autre modèle et/ou qu'on change de fournisseur.

L'objectif de la présente invention est de s'affranchir de cette étape de configuration en vue de déterminer lesdites données de corrélation, cette étape pouvant être considérée comme pénalisante car nécessitant des tests et travaux en amont de l'utilisation de nouvelles batteries. L'invention remédie aux carences des méthodes précédentes en proposant un procédé d'auto-paramétrage qui est exécuté automatiquement et systématiquement à chaque remplacement de batterie. Elle améliore par conséquent très sensiblement le confort d'utilisation des batteries existantes.

A cet effet, le procédé d'auto-paramétrage des conditions de charge d'une batterie d'accumulateurs électrochimiques, notamment une batterie lithium classiquement connectée à une source d'alimentation apte à la charger, comprenant la détection d'au moins un point d'inflexion dans la courbe de tension de charge de la batterie $U_{bat}$ fonction du taux de charge électrique exprimé en pourcentage de la capacité C de la batterie, est tel, selon l'invention, qu'il comprend :

- pour chaque point p d'inflexion détecté, une déconnexion de la batterie de sa source d'alimentation pendant une période de relaxation prédéterminée
- à l'issue de ladite période de relaxation, la mémorisation de la tension à vide $U_{xR}$ de la batterie pour chacun des points d'inflexion, ladite tension à vide $U_{xR}$ constituant un marqueur d'un niveau de charge intermédiaire utilisable comme seuil d'arrêt de charge au cours de la charge d'une batterie.

Ces phases sont répétées pour chacun des points d'inflexion ou seuils à déterminer : il y a en général deux ou trois seuils correspondant à autant de niveaux de charge intermédiaires, et donc plusieurs possibilités d'arrêts de charge au cours de la recharge d'une batterie pour allonger sa durée de vie. L'objectif de l'invention est bien atteint, à savoir proposer les moyens de s'adapter au mieux au profil de charge de chaque batterie pour le gérer optimalement, c'est-à-dire de la façon la plus adaptée à chaque batterie traitée, dans la perspective finale d'optimiser son fonctionnement à long terme.

Selon un mode opératoire propre à l'invention, la détection d'un point d'inflexion s'effectue par la localisation d'un maximum d'une fonction donnant la pente de points répartis sur la courbe de charge de la batterie, ladite fonction étant $P = \Delta U_{bat}/\Sigma I_{bat}$, pour laquelle :

- $\Delta U_{bat}$ représente la différence de la tension de charge entre deux points distincts de la courbe de charge de la batterie à deux instants $t$ et $t + \Delta t$, et
- $\Sigma I_{bat}$ représente la somme des valeurs de courant $I_{bat}$ entrants dans la batterie, mesurés selon un échantillonnage périodique de périodicité $T_e$ dans l'intervalle de temps $\Delta t$ correspondant à la durée de charge s'écoulant entre lesdits points.

Le principe qui est à la base du mode opératoire de l'invention réside en ce que, pour que la détection des points d'inflexion soit fiable, on a considéré qu'il faut qu'elle repose sur la mesure de la dérivée de la fonction exprimant la tension de la batterie en fonction de la charge stockée, et non en fonction du temps. On sait que la dérivée d'une fonction fournit une mesure de la pente de la courbe de la fonction, ici la courbe de charge de la batterie, en un point donné. Elle permet de comprendre l'apparence locale de la courbe, notamment de savoir quand se produisent les inflexions et quelle est leur nature. Cette approche permet par ailleurs au procédé de fonctionner quelles que soient les fluctuations du courant dans la batterie, qui peut même s'inverser temporairement lorsque le système consomme plus d'énergie qu'il n'en reçoit.

Pour en arriver à la fonction $P = \Delta U_{bat}/\Sigma I_{bat}$ utilisée dans le procédé de l'invention, on part de la pente de la courbe en un point donné définie, donc, par la dérivée calculée en ce point, et qui est approximée par la formule : $dU_{bat}/dQ_{bat} \approx \Delta U_{bat}/\Delta Q_{bat}$, $\Delta U_{bat}$ étant la variation de tension de la batterie (en volts) entre 2 points de la courbe de charge et $\Delta Q_{bat}$ étant la variation de charge de la batterie (en coulombs ou ampères-heure) entre ces 2 points. Cette variation de charge $\Delta Q_{bat}$ entre deux points de la courbe de charge est de fait égale à l'intégrale du courant par rapport au temps, calculée sur la durée de charge séparant en pratique ces deux points.

Dans un système numérique basé sur un échantillonnage périodique de la tension et du courant, on peut approximer cette intégrale par une somme discrète :

$$\Delta Q_{bat} \approx \Sigma I_{bat} \cdot T_e$$

où $T_e$ est la période d'échantillonnage (en secondes) du système numérique et $I_{bat}$ le courant de charge de la batterie (en ampères) au $n^{ième}$ instant d'échantillonnage. On comprend que plus $T_e$ est faible, plus l'approximation fournie par la somme ci-dessus est précise, et plus le nombre de termes à additionner pour une même durée d'intégration est évidemment élevé. La pente de la courbe en un point donné $\Delta U_{bat}/\Delta Q_{bat}$, peut donc s'exprimer sous la forme $\Delta U_{bat}/\Sigma I_{bat} \cdot T_e$.

Comme le terme $T_e$ de la relation est constant (par exemple 1 minute) et qu'on cherche à détecter où se trouvent les points de pente maximale de la courbe de tension de charge sans avoir besoin de connaître la valeur exacte de la pente, on peut se contenter de localiser les maxima de la fonction $P$ :

$$P = \Delta U_{bat}/\Sigma I_{bat}$$

C'est la relation utilisée par le procédé de l'invention.

Selon ce procédé, une pente $P_n$ est calculée de manière itérative entre des couples de points de la courbe de charge de la batterie dont l'écartement sur la courbe correspond à une capacité chargée $c_c$ dans la batterie sensiblement égale à un pourcentage $p$ prédéfini de la capacité $C$ de la batterie. De manière avantageuse, dans l'invention, le pourcentage $p$ de capacité chargée $c_c$ dans la batterie peut être compris entre 3% et 5% de la capacité $C$ de la batterie, de préférence égal à 4%. Ce pourcentage $p$ est choisi avec une valeur suffisamment élevée pour que la variation de la tension corresponde à une augmentation significative et mesurable, qui permet de limiter l'imprécision liée aux tolérances sur la mesure de la tension et du courant. L'inconvénient résultant du choix d'une valeur élevée est que la durée qui sépare deux mesures de pente est relativement longue, conduisant à un nombre total de mesures le long de la courbe de charge qui n'est guère élevé, et dont le caractère significatif et efficace dans la recherche des points d'inflexion de la courbe peut par conséquent être discuté.

Dans le procédé de l'invention, pour répondre à ce problème, il est prévu de mener de front plusieurs calculs de pente en les décalant d'une valeur de charge sensiblement inférieure à celle qui est utilisée dans le calcul de la pente. La valeur de capacité chargée de décalage est de préférence un sous-multiple de la valeur de capacité chargée de calcul de pente. Ainsi, plus précisément, la pente $P_n$ est en réalité calculée selon une périodicité correspondant à une augmentation de capacité chargée dans la batterie égale à une fraction $f$ de la capacité chargée $c_c$ utilisée pour le calcul de la pente. A chaque fois que la charge de la batterie aura progressé de cette fraction, une nouvelle valeur de pente sera calculée et disponible avec la précision indiqué auparavant, considérée comme appropriée. Avantageusement, la fraction $f$ est comprise entre 1/5 et 1/3 de la capacité chargée $c_c$, de préférence égale à 1/4 de celle-ci.

Si on considère donc par exemple que la pente $P_n$ est calculée entre deux points de la courbe de charge de la batterie correspondant à une capacité chargée égale à un pourcentage de 4% de la capacité $C$ de la batterie, le système effectue en réalité séquentiellement des calculs de pente sur des plages de même longueur équivalent à 4% de charge, mais décalées les unes des autres d'une distance correspondant à une valeur de charge par exemple de 1 % de capacité chargée. Dans ce cas, concrètement, 4 calculs de pente entrelacés espacés de 1 % seront effectués à la place d'un seul calcul, et le nombre de mesures de pente est considérablement plus élevé, certainement plus significatif pour une recherche aboutie des points d'inflexion de la courbe de charge.

Selon le procédé de l'invention, la pente $P_n$ calculée est ensuite lissée par un filtre numérique à réponse impulsionnelle infinie qui calcule une pente filtrée $PF_n$. Ce filtre utilise classiquement une équation de récurrence pour lisser le résultat, c'est-à-dire la valeur de la pente, en fonction de sa sortie passée et de la valeur $P_n$. Selon une possibilité, le filtre numérique à réponse impulsionnelle infinie utilisé en l'espèce est du type :

$$PF_n = (k \cdot PF_{n-1} + P_n) / (k + 1)$$

k étant un coefficient de filtrage compris entre 5 et 10. De préférence, le coefficient de filtrage k sélectionné est égal à 7.

Le tracé de la courbe de la fonction $PF_n$ exprimée ci-dessus se développe tout au long de la courbe de charge de la batterie, associant à chaque point de celle-ci un point de la courbe $PF_n$ qui donne sa pente lissée. Il est alors facile d'observer que cette courbe $PF_n$ atteint un maximum local en plusieurs endroits. Dans le fonctionnement qui sera décrit plus précisément dans la suite, dès que la courbe de la fonction $PF_n$ redescend, on considère qu'un maximum été détecté, chaque maximum correspondant à un point d'inflexion recherché de la courbe de charge de la batterie. Selon l'invention, le procédé comporte :

- la détection du début de chaque décroissance de la courbe $PF_n$ ;
- l'assimilation de ce début de chaque décroissance à un point d'inflexion p.

Ensuite, conformément à ce qui a été indiqué auparavant, pour chaque point p d'inflexion détecté, le procédé comporte une déconnexion de la batterie pendant une période de relaxation prédéterminée et, à l'issue de ladite période de relaxation, la mémorisation de la tension à vide $U_{xR}$ de la batterie pour chacun des points d'inflexion, ladite tension à vide $U_{xR}$ constituant un marqueur d'un niveau de charge intermédiaire utilisable comme seuil d'arrêt de charge au cours d'un processus de recharge d'une batterie.

Additionnellement, l'invention peut comporter la mémorisation, pour chaque point d'inflexion p détecté, de la valeur $U_{xC}$ de la tension de charge de la batterie. Dans ce cas, plus généralement, le procédé d'auto-paramétrage de l'invention mesure et mémorise la tension atteinte $U_{1C}$ au premier point d'inflexion, coupe la charge pendant un temps de relaxation donné (par exemple 5 minutes) puis remesure la tension de la batterie $U_{1R}$ et la mémorise également. La charge est réactivée et le processus se poursuit pour déterminer les seuils $U_{2C}/U_{2R}$, $U_{3C}/U_{3R}$... correspondant aux autres points d'inflexion, autrement dit aux autres niveaux de charges, bien identifiables par cette méthode. Alternativement, toujours pour chaque point d'inflexion p détecté, la valeur de la tension de charge $U_{xC}$ est obtenue par extrapolation réalisée à partir de la valeur de la tension à vide $U_{xR}$ mémorisée, par addition à $U_{xR}$ d'une valeur prédéterminée liée à la durée de la période de relaxation.

Le procédé comporte par ailleurs une étape de validation des valeurs de tension trouvées pour les points d'inflexion, telle que :

- les valeurs de tension de charge $U_{xC}$ et de tension à vide $U_{xR}$ sont comparées, pour chaque point d'inflexion p, à des valeurs seuils inférieures ou supérieures prédéterminées ;
- si les tests de comparaison sont positifs, les valeurs de tension de charge $U_{xC}$ et de tension à vide $U_{xR}$ sont validées et utilisées comme marqueurs de seuils d'arrêts de charge, respectivement en charge et après relaxation.

Lorsque tous les seuils sont déterminés, le procédé clôture la procédure d'auto-détection des seuils d'arrêt de charge d'une batterie. Lesdits seuils étant détectés et mémorisés, le paramétrage des conditions de charge d'une batterie est considéré comme réalisé. Il est à noter que le procédé décrit auparavant, bien qu'utilisant une méthode d'intégration du courant par rapport au temps, se distingue de la méthode de charge par comptage coulométrique par le fait que l'intégration mathématique du courant n'est appliquée que sur une durée restreinte, et non sur l'intégralité du processus de charge, ce qui limite les dérives à long terme. On rappelle par ailleurs, que ce procédé ne sert pas à calculer le niveau de charge actuel de la batterie mais à déterminer automatiquement le (ou les) seuil(s) d'arrêt de charge.

L'invention sera mieux comprise à l'aide de la description détaillée suivante du procédé d'auto-paramétrage des conditions de charge d'une batterie, en référence aux dessins annexés pour lesquels :

[Fig. 1] représente une pluralité de courbes avec un axe des abscisses qui mesure le taux de charge de la batterie en pourcentage (%), dont principalement la courbe de tension de charge $U_{bat}$ de la batterie et la courbe de la pente filtrée $PF_n$, ainsi que les courbes en escalier entrelacées des points de la courbe de charge dont la pente est mesurée ;

[Fig. 2] montre un organigramme détaillant le traitement de l'auto-détection des points d'inflexion ; et

[Fig. 3] représente un organigramme montrant les détails du calcul de la pente filtrée pour chaque point p considéré.

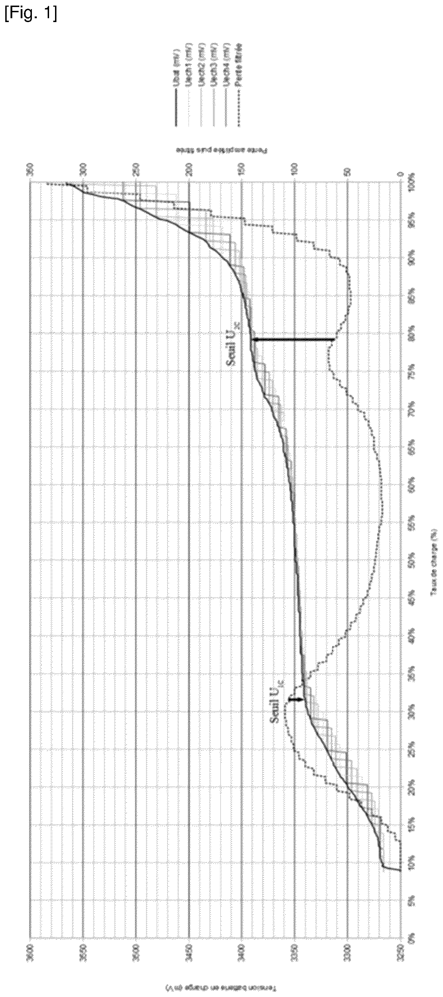

La figure 1 montre à titre essentiel la courbe de charge, c'est-à-dire la courbe de la tension de charge $U_{bat}$ (en mV) (en ordonnées à gauche de la figure) en fonction du taux de charge (en pourcentage), pour une batterie LFP (Lithium Fer Phosphate). Elle fait notamment apparaître, dans une portion médiane d'allure relativement plane, deux seuils $U_{1C}$ et $U_{2C}$ qui sont précisément les points d'inflexion recherchés, caractéristiques des seuils de charge $U_{xC}$ d'une telle batterie, que l'on veut notamment identifier pour déterminer des marqueurs permettant de procéder à des recharges qui n'obèrent pas la durée de vie de la batterie.

Une seconde courbe présente en ordonnées (à droite de la figure) la pente amplifiée puis filtrée $PF_n$ des points de la courbe précédente, également en fonction du taux de charge de la batterie, et elle présente par conséquent le même axe d'abscisses. Cette seconde courbe présente deux maxima, et les seuils d'arrêt de charge identifiés $U_{1c}$ et $U_{2c}$ correspondent bien, conformément au procédé de l'invention, au début de chaque décroissance de la courbe $PF_n$.

Longeant la courbe $U_{bat}$, juste en dessous de son tracé, quatre courbes en escalier entrelacées $U_{ech1}$, $U_{ech2}$, $U_{ech3}$ et $U_{ech4}$ montrent les couples successifs de points de calcul des pentes de la courbe principale $U_{bat}$, situés à une distance correspondant à 4% de capacité chargée dans la batterie, chacune de ces courbes entrelacées $U_{ech1}$, $U_{ech2}$, $U_{ech3}$ et $U_{ech4}$ se développant pour des points séparés d'une distance correspondant à 1% de capacité chargée dans la batterie. Comme évoqué auparavant, 4 calculs de pente entrelacés espacés de 1 % sont donc effectués à la place d'un seul calcul tous les 4%, ce dernier garantissant certes une variation de la tension significative pour le calcul de la pente mais conduisant à un nombre réduit de valeurs obtenues. Au contraire, l'entrelac des courbes à chaque variation de 1% du taux de charge permet d'obtenir un nombre de mesures de pente bien plus élevé, et par conséquent beaucoup plus significatif dans la perspective de la recherche des points d'inflexion.

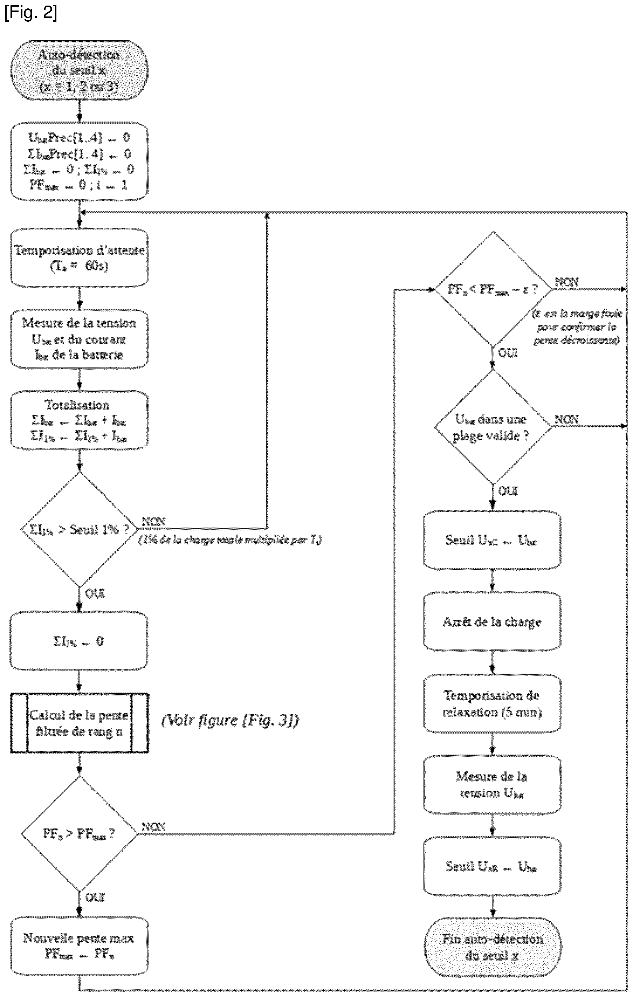

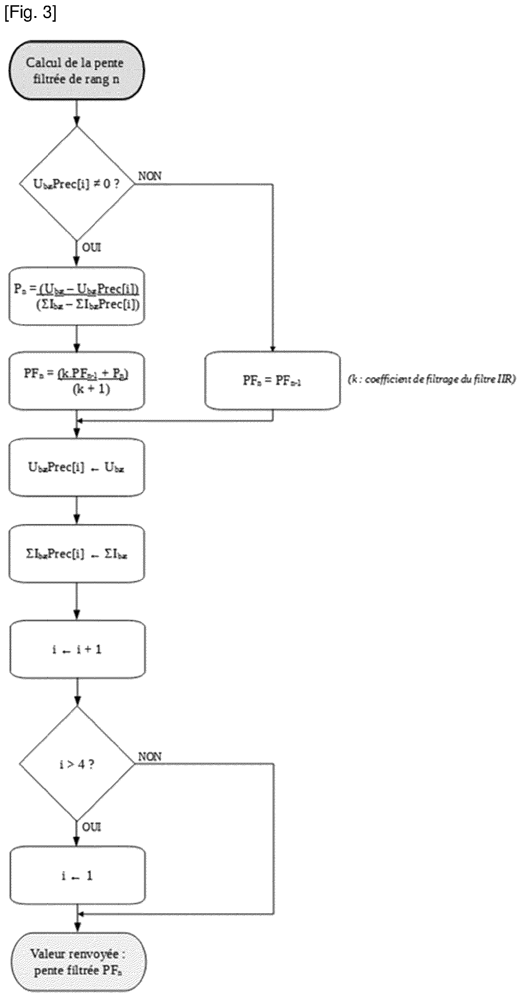

En référence à la figure 2, un exemple d'implémentation du procédé de l'invention est illustré par l'organigramme présenté. Pour chacun des seuils à déterminer, on commence par initialiser les variables qui servent à totaliser le courant mais aussi par mémoriser les grandeurs principales calculées à chaque tour de boucle. La boucle logicielle commence par une attente d'une durée fixée $T_e$ qui vaut ici 1 minute, puis on mesure la tension $U_{bat}$ aux bornes de la batterie et le courant $I_{bat}$ injecté ou prélevé dans la batterie. On additionne ce dernier à deux totaux $\Sigma I_{bat}$ et $\Sigma I_{1\%}$ dévolus à des fonctions différentes, $\Sigma I_{bat}$ étant utilisé dans le calcul de pente et $\Sigma I_{1\%}$ étant comparé à un seuil correspondant à 1 % de la capacité de la batterie multipliée par la durée $T_e$ qui sépare 2 mesures successives. Si ledit seuil est dépassé, on remet le total $\Sigma I_{1\%}$ à 0 et on effectue le calcul de la pente selon la méthode illustrée par la figure 3. Sinon, on reboucle à l'étape d'attente pour continuer le cumul.

Le calcul de la pente est montré en figure 3. Il n'est effectué que si une précédente mesure de $U_{bat}$ a déjà été mémorisée dans une table $U_{bat}Prec$ qui comporte 4 valeurs cycliques d'index allant de 1 à 4, $U_{bat}Prec[1]$ à $U_{bat}Prec[4]$. On comprend aisément que ce n'est donc qu'à la 5ème mesure que le calcul itératif de la pente $P_n$ peut commencer. En l'occurrence, comme déjà mentionné, calculer la pente $P_n$ revient à diviser l'écart entre la tension de la batterie $U_{bat}$ et la valeur qu'elle avait 4 itérations de mesure auparavant $U_{bat}Prec[i]$ par l'écart entre le totalisateur de courant $\Sigma I_{bat}$ et la valeur qu'il avait 4 itérations de mesure auparavant $\Sigma I_{bat}Prec[i]$. Immédiatement après ce calcul de pente $P_n$, on injecte la pente calculée dans un filtre numérique de premier ordre dit à réponse impulsionnelle infinie (IIR), dont le coefficient est choisi de préférence égal à 7, et qui obéit à la relation suivante :

$$PF_n = (k \cdot PF_{n-1} + P_n) / (k + 1)$$

Ensuite, on mémorise la valeur $U_{bat}$ de la tension de la batterie dans $U_{bat}Prec[i]$ et la valeur $\Sigma I_{bat}$ du totalisateur de courant dans $\Sigma I_{bat}Prec[i]$ avant d'incrémenter la valeur de i. Celle-ci est ramenée à 1 si elle dépasse 4, un test étant systématiquement effectué à cet effet. Ainsi, on entrelace 4 calculs de pente correspondant chacun à une augmentation de 4 % de la charge de la batterie, mais la valeur filtrée de la pente $PF_n$ est mise à jour à chaque progression de charge de la batterie de 1 %.

Une fois la pente filtrée $PF_n$ de rang n calculée, la suite du procédé est montrée en figure 2, et consiste en une série de tests. On localise d'abord un maximum local de la pente en comparant la valeur courante $PF_n$ à une valeur maximale $PF_{max}$ obtenue jusqu'ici et mémorisée, permettant la détection d'une légère décroissance - de l'ordre de quelques pourcents de la valeur maximale atteinte - par comparaison de la valeur courante $PF_n$ avec une valeur $PF_{max} - \varepsilon$, $\varepsilon$ étant prédéterminé et correspondant à ces quelques pourcents. C'est le début de la décroissance ainsi trouvé qui sert, dans le procédé de l'invention, à identifier les niveaux de charge remarquables, les seuils de charge à mémoriser, comme cela ressort bien de la figure 1.

On vérifie alors que la tension $U_{bat}$ de la batterie est comprise dans une plage plausible, selon le seuil que l'on recherche. Sur la courbe de la figure 1, le seuil n° 1 (entre 30 et 35 % de charge) n'est par exemple validé que si $U_{bat} < 3350$mV alors que le seuil n° 2 (entre 75 et 80 % de charge) n'est validé que si $U_{bat} > 3370$mV. Dans le premier cas, puisqu'on se situe à un niveau de charge relativement bas, la comparaison se fait par rapport à une limite supérieure, alors que dans le second cas, le niveau de charge étant relativement élevé pour une telle batterie, la comparaison se fait par rapport à une limite inférieure. Si la comparaison est validée, on mémorise la valeur $U_{bat}$ dans une variable $U_{xC}$, x étant le numéro du point d'inflexion ou seuil recherché. Puis on stoppe la charge pendant un temps prédéfini (5 minutes dans l'exemple de la figure 2) et on remesure la tension de la batterie après relaxation pour la stocker dans $U_{xR}$. Ensuite, on peut réactiver la charge pour éventuellement détecter un autre seuil. Il est à noter que les seuils $U_{xR}$ ainsi trouvés sont utilisables dans le cadre du procédé d'arrêt de charge décrit dans le brevet EP3220471 mentionné auparavant.

Selon une possibilité additionnelle, le procédé de l'invention peut également comporter une mémorisation de la valeur du totalisateur de courant associé à chaque seuil, et un contrôle visant à déterminer que l'écart de courant totalisé entre 2 seuils est suffisant pour exclure d'éventuelles détections de seuils secondaires non significatifs.

Une installation pour la mise en oeuvre du procédé décrit ci-dessus, qui n'est pas l'objet de la présente invention, est décrite dans le brevet EP3220471, le capteur de courant étant indispensable pour le présent procédé. Il peut s'agir d'une résistance série de très faible valeur (< 1Ω) intercalée entre la batterie et la source d'énergie, associée ou non à un circuit d'amplification, ou bien d'un capteur de courant à effet Hall ou magnéto-résistif.

Dans la description qui précède, selon une application possible, la batterie peut être destinée à alimenter le moteur d'entraînement d'un élément mobile de fermeture, d'occultation, de protection solaire ou d'écran, par exemple un volet motorisé. Le procédé de l'invention concerne de manière générale une batterie d'accumulateurs électrochimiques, notamment une batterie lithium, destinée à être chargée par connexion à une source d'alimentation externe et, par exemple, à alimenter en énergie électrique le moteur électrique d'entraînement d'un tel élément mobile. La présente invention ne se limite par ailleurs pas au type de batterie explicitement mentionné auparavant dans la description ou indiqué sur la figure 1, mais peut s'appliquer à tout type de batterie, notamment aux batteries Lithium telles que les batteries Lithium-Ion, mais aussi aux batteries au plomb, NiMH etc.

**Revendications**

1. Procédé d'auto-paramétrage des conditions de charge d'une batterie d'accumulateurs électrochimiques, notamment une batterie lithium, ladite batterie étant connectée à une source d'alimentation apte à la charger, comprenant la détection d'au moins un point p d'inflexion dans la courbe de tension de charge de la batterie $U_{bat}$ fonction du taux de charge électrique exprimé en pourcentage de la capacité C de la batterie, **caractérisé par** :

- pour chaque point p d'inflexion détecté, une déconnexion de la batterie de sa source d'alimentation pendant une période de relaxation prédéterminée ;
- à l'issue de ladite période de relaxation, la mémorisation de la tension à vide $U_{xR}$ de la batterie pour chacun des points d'inflexion, ladite tension à vide $U_{xR}$ constituant un marqueur d'un niveau de charge intermédiaire utilisable comme seuil d'arrêt de charge au cours de la charge d'une batterie.

2. Procédé d'auto-paramétrage des conditions de charge d'une batterie d'accumulateurs selon la revendication précédente, dans lequel la détection d'un point d'inflexion s'effectue par la localisation d'un maximum d'une fonction donnant la pente de points répartis sur la courbe de charge de la batterie, ladite fonction étant $P = \Delta U_{bat}/\Sigma I_{bat}$, pour laquelle :

- $\Delta U_{bat}$ représente la différence de la tension de charge entre deux points distincts de la courbe de charge de la batterie à deux instants t et t + $\Delta t$, et
- $\Sigma I_{bat}$ représente la somme des valeurs de courant $I_{bat}$ entrants dans la batterie, mesurés selon un échantillonnage périodique de périodicité $T_e$ dans l'intervalle de temps $\Delta t$ correspondant à la durée de charge s'écoulant entre lesdits points.

3. Procédé d'auto-paramétrage des conditions de charge d'une batterie d'accumulateurs selon la revendication précédente, dans lequel une pente $P_n$ est calculée de manière itérative entre des couples de points de la courbe de charge de la batterie dont l'écartement sur la courbe correspond à une capacité chargée $c_c$ dans la batterie sensiblement égale à un pourcentage p prédéfini de la capacité C de la batterie.

4. Procédé d'auto-paramétrage des conditions de charge d'une batterie d'accumulateurs selon la revendication précédente, dans lequel le pourcentage p de capacité chargée $c_c$ dans la batterie est compris entre 3% et 5% de la capacité C de la batterie, de préférence égal à 4%.

5. Procédé d'auto-paramétrage des conditions de charge d'une batterie d'accumulateurs selon l'une des revendications 3 et 4, dans lequel la pente $P_n$ est calculée selon une périodicité correspondant à une augmentation de capacité chargée dans la batterie égale à une fraction f de la capacité chargée $c_c$.

6. Procédé d'auto-paramétrage des conditions de charge d'une batterie d'accumulateurs selon la revendication précédente, dans lequel la fraction f est comprise entre 1/5 et 1/3 de la capacité chargée $c_c$, de préférence égale à 1/4 de celle-ci.

7. Procédé d'auto-paramétrage des conditions de charge d'une batterie d'accumulateurs selon l'une des revendications 5 et 6, dans lequel la pente $P_n$ calculée est lissée par un filtre numérique à réponse impulsionnelle infinie qui calcule une pente filtrée $PF_n$.

8. Procédé d'auto-paramétrage des conditions de charge d'une batterie d'accumulateurs selon la revendication précédente, dans lequel le filtre numérique à réponse impulsionnelle infinie est du type :

$$PF_n = (k \cdot PF_{n-1} + P_n) / (k + 1)$$

k étant un coefficient de filtrage compris entre 5 et 10.

9. Procédé d'auto-paramétrage des conditions de charge d'une batterie d'accumulateurs selon la revendication précédente, dans lequel le coefficient de filtrage k est égal à 7.

10. Procédé d'auto-paramétrage des conditions de charge d'une batterie d'accumulateurs selon l'une des revendications 7 à 9, comportant :

- la détection du début de chaque décroissance de la courbe $PF_n$ ;
- l'assimilation de ce début de chaque décroissance à un point d'inflexion p.

11. Procédé d'auto-paramétrage des conditions de charge d'une batterie d'accumulateurs selon la revendication précédente, comportant la mémorisation, pour chaque un point d'inflexion p détecté, de la valeur $U_{xC}$ de la tension de charge de la batterie.

12. Procédé d'auto-paramétrage des conditions de charge d'une batterie d'accumulateurs selon la revendication 10, comportant pour chaque point d'inflexion p détecté, la valeur de la tension de charge $U_{xC}$ est obtenue par extrapolation réalisée à partir de la valeur de la tension à vide $U_{xR}$ mémorisée, par addition à $U_{xR}$ d'une valeur prédéterminée liée à la durée de la période de relaxation.

13. Procédé d'auto-paramétrage des conditions de charge d'une batterie d'accumulateurs selon la revendication précédente, dans lequel :

- les valeurs de tension de charge $U_{xC}$ et de tension à vide $U_{xR}$ sont comparées, pour chaque point d'inflexion p, à des valeurs seuils inférieures ou supérieures prédéterminées ;
- si les tests de comparaison sont positifs, les valeurs de tension de charge $U_{xC}$ et de tension à vide $U_{xR}$ sont validées et utilisées comme marqueurs de seuils d'arrêts de charge, respectivement en charge et après relaxation.

[Fig. 1]

[Fig. 2]

[Fig. 3]

```
            ╭─────────────────╮
            │ Calcul de la pente │
            │  filtrée de rang n │
            ╰─────────────────╯
                     │
                     ▼
                  ╱────────╲
                 ╱          ╲        NON
                ⟨ U_bat Prec[i] ≠ 0 ? ⟩──────────────────┐
                 ╲          ╱                            │
                  ╲────────╱                             │
                     │ OUI                               │
                     ▼                                   │
        ┌──────────────────────┐                         │
        │ P_n = (U_bat − U_bat Prec[i]) │                │
        │       (ΣI_bat − ΣI_bat Prec[i]) │              │
        └──────────────────────┘                         │
                     │                                   ▼
                     ▼                    ┌──────────────────────┐
        ┌──────────────────────┐          │   PF_n = PF_{n-1}    │  (k : coefficient de filtrage du filtre IIR)
        │ PF_n = (k.PF_{n-1} + P_n) │      └──────────────────────┘
        │        (k + 1)         │                  │
        └──────────────────────┘                   │
                     │◄──────────────────────────────┘
                     ▼
        ┌──────────────────────┐
        │  U_bat Prec[i] ← U_bat  │
        └──────────────────────┘
                     │
                     ▼
        ┌──────────────────────┐
        │ ΣI_bat Prec[i] ← ΣI_bat │
        └──────────────────────┘
                     │
                     ▼
        ┌──────────────────────┐
        │      i ← i + 1        │
        └──────────────────────┘
                     │
                     ▼
                  ╱────────╲
                 ╱          ╲   NON
                ⟨   i > 4 ?   ⟩────────────────┐
                 ╲          ╱                  │
                  ╲────────╱                   │
                     │ OUI                     │
                     ▼                         │
        ┌──────────────────────┐               │
        │        i ← 1         │               │
        └──────────────────────┘◄──────────────┘
                     │
                     ▼
            ╭─────────────────╮
            │ Valeur renvoyée : │
            │  pente filtrée PF_n │
            ╰─────────────────╯
```

Europäisches
Patentamt

European
Patent Office

Office européen
des brevets

# RAPPORT DE RECHERCHE EUROPEENNE

Numéro de la demande

EP 25 15 4005

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | JP 2006 351418 A (MATSUSHITA ELECTRIC IND CO LTD) 28 décembre 2006 (2006-12-28) | 1-6,13 | INV. H02J7/00 |
| Y | * le document en entier * | 11 | G01R31/36 |
| | ----- | | G01R31/367 |
| X | US 2024/012063 A1 (LIU JINGYUAN [CN] ET AL) 11 janvier 2024 (2024-01-11) | 1,7-10, 13 | G01R31/382 H01M10/44 |
| Y | * alinéas [0015], [0048], [0081] - [0087], [0100]; revendication 11; figures 6-8,17 * | 11,12 | |
| | ----- | | |
| X | US 2020/212511 A1 (ADACHI NORIKAZU [JP] ET AL) 2 juillet 2020 (2020-07-02) * alinéas [0048] - [0053], [0068]; figures 1,3,5 * | 1 | |
| | ----- | | |
| X | US 2021/364575 A1 (HORIUCHI YUTO [JP] ET AL) 25 novembre 2021 (2021-11-25) * alinéas [0064] - [0066]; figure 5 * | 1 | |
| | ----- | | |
| X | US 2016/254687 A1 (TANAKA AKIHIDE [JP] ET AL) 1 septembre 2016 (2016-09-01) * alinéas [0073] - [0090]; figures 2,5 * | 1 | DOMAINES TECHNIQUES RECHERCHES (IPC) |
| | ----- | | H02J |
| Y | US 2002/113594 A1 (SATAKE SHUJI [JP]) 22 août 2002 (2002-08-22) * figure 3 * | 12 | G01R H01M |
| | ----- | | |

Le présent rapport a été établi pour toutes les revendications

| Lieu de la recherche | Date d'achèvement de la recherche | Examinateur |
|---|---|---|
| Munich | 19 mai 2025 | Tchegho Kamdem, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 15 4005

19-05-2025

| Document brevet cité au rapport de recherche | Date de publication | Membre(s) de la famille de brevet(s) | Date de publication |
|---|---|---|---|
| JP 2006351418 A | 28-12-2006 | JP 4753636 B2 | 24-08-2011 |
| | | JP 2006351418 A | 28-12-2006 |
| US 2024012063 A1 | 11-01-2024 | CN 117388734 A | 12-01-2024 |
| | | DE 102022119282 A1 | 11-01-2024 |
| | | US 2024012063 A1 | 11-01-2024 |
| US 2020212511 A1 | 02-07-2020 | JP 6760233 B2 | 23-09-2020 |
| | | JP 2019050151 A | 28-03-2019 |
| | | US 2020212511 A1 | 02-07-2020 |
| | | WO 2019049719 A1 | 14-03-2019 |
| US 2021364575 A1 | 25-11-2021 | CN 112166524 A | 01-01-2021 |
| | | JP 7403075 B2 | 22-12-2023 |
| | | JP WO2019230464 A1 | 26-07-2021 |
| | | US 2021364575 A1 | 25-11-2021 |
| | | WO 2019230464 A1 | 05-12-2019 |
| US 2016254687 A1 | 01-09-2016 | CN 105723559 A | 29-06-2016 |
| | | EP 3076478 A1 | 05-10-2016 |
| | | JP 6192738 B2 | 06-09-2017 |
| | | JP WO2015080285 A1 | 16-03-2017 |
| | | US 2016254687 A1 | 01-09-2016 |
| | | WO 2015080285 A1 | 04-06-2015 |
| US 2002113594 A1 | 22-08-2002 | GB 2373864 A | 02-10-2002 |
| | | JP 3869676 B2 | 17-01-2007 |
| | | JP 2002234408 A | 20-08-2002 |
| | | US 2002113594 A1 | 22-08-2002 |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3220471 A
- JP 2006351418 A
- US 2024012063 A1